(19) Europäisches Patentamt / European Patent Office / Office européen des brevets

(11) **EP 2 978 717 B1**

(12) **FASCICULE DE BREVET EUROPEEN**

(45) Date de publication et mention
de la délivrance du brevet:
**19.08.2020 Bulletin 2020/34**

(21) Numéro de dépôt: **14718679.5**

(22) Date de dépôt: **26.03.2014**

(51) Int Cl.:
**C03C 23/00** $^{(2006.01)}$

(86) Numéro de dépôt international:
**PCT/FR2014/050713**

(87) Numéro de publication internationale:
**WO 2014/155008 (02.10.2014 Gazette 2014/40)**

(54) **PROCEDE DE TRAITEMENT PAR UN FAISCEAU D'IONS POUR PRODUIRE DES MATERIAUX EN VERRE SUPERHYDROPHILES**

IONENSTRAHLBEHANDLUNGSVERFAHREN ZUR HERSTELLUNG EINES SUPERHYDROPHILEN GLASMATERIALS

ION BEAM TREATMENT METHOD FOR PRODUCING SUPERHYDROPHILIC GLASS MATERIALS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.03.2013 FR 1300719**

(43) Date de publication de la demande:
**03.02.2016 Bulletin 2016/05**

(73) Titulaire: **IONICS France**
**14200 Hérouville-Saint-Clair (FR)**

(72) Inventeurs:
• **BUSARDO, Denis**
  **F-14510 Gonneville-sur-mer (FR)**
• **GUERNALEC, Frédéric**
  **F-35340 Liffre (FR)**

(74) Mandataire: **Plasseraud IP**
**66, rue de la Chaussée d'Antin**
**75440 Paris Cedex 09 (FR)**

(56) Documents cités:
**WO-A1-2011/001065      WO-A2-2012/001325**
**US-A- 4 948 760        US-B1- 6 300 641**

**Description**

L'invention a pour objet un procédé de traitement par un faisceau d'ions d'un matériau en verre et vise à réduire fortement la formation de la buée sur une longue durée. Le procédé de l'invention s'applique sur la surface d'un substrat en verre, par exemple transparent, tel qu'un miroir, une lentille ou d'un verre en feuille de manière à ce que ladite surface acquiert des propriétés hydrophiles, voire « superhydrophiles ».

On considère qu'une surface présente des propriétés hydrophiles quand cette surface est caractérisée par des angles de contact de gouttes d'eau inférieurs à 45°.

On considère qu'une surface présente des propriétés dites « superhydrophiles » quand cette surface est caractérisée par des angles de contact de gouttes d'eau inférieurs à 20°, par exemple inférieurs à 10°. Dans ces conditions la surface présente notamment des propriétés antibuée.

Durant les saisons froides il est bien connu que les pare-brise et les vitres d'automobiles, les verres de bâtiments, les lunettes se recouvrent d'une buée résultant du fait que la surface des objets précités est à une température inférieure à la température de rosée de l'atmosphère ambiante. Il se produit alors un condensat d'humidité qui constitue une gêne majeur selon les conditions de visibilité exigée. Cette gêne se traduit par une réfraction de la lumière au travers des fines gouttelettes qui tapissent la surface, provoquant une déformation des images et aboutissant à une perte de visibilité. Cette gêne visuel peut par exemple augmenter les risques d'accident sur la route, entacher un diagnostic médical lorsqu'on utilise un miroir dentaire ou des lentilles endoscopiques.

Des accessoires mécaniques comme les essuie glace permettre d'évacuer la buée déposée sur un pare brise. Des produits chimiques hydrophiles ou hydrophobes peuvent également être appliqués à la surface pour éviter la formation de buée. Ces produits chimiques ont toutefois une efficacité limitée sur la durée, un lavage répété à l'eau suffit à les faire disparaître.

Il existe des procédés pour rendre une surface hydrophile ou hydrophobe.

On citera un premier procédé antibuée pour un miroir recouvert d'une couche polymère soumise à une lumière ultraviolette puis immergé dans une solution aqueuse alcaline pour former des radicaux acides en forte concentration qui rend la surface du polymère hydrophile. La surface du polymère finit toutefois par se recouvrir de contaminants, perdant ainsi progressivement ses caractéristiques hydrophiles. Un lavage est alors nécessaire qui peut sur une durée relativement courte détruire le polymère.

On citera un second procédé consistant à greffer sur une couche polymère des monomères comportant des groupes hydrophiles, d'autres monomères comportant des groupes hydrophobes. Dans ces conditions l'angle de contact d'une goutte d'eau ne descend pas en deca de 50°, ne présentant pas de fait des capacités antibuée suffisante.

Un autre procédé consiste à déposer une couche d'oxyde métallique ($TiO_2$, $SnO_2$, $ZnO$, $Fe_2O_3$) d'une épaisseur de quelques dizaines voire de quelques centaines de nanomètres, présentant une fonction photocatalytique développant des propriétés hydrophiles voire superhydrophiles sous l'effet de la lumière UV, conjuguées à des propriétés anti-moisissures, anti-salissures. Cette hydrophilie voire superhydrophilie peut toutefois s'estomper dans le temps si la surface est placée par exemple dans l'obscurité sur une durée relativement longue. Le caractère hydrophile de surface dépend donc de l'intensité de la lumière, de sa longueur d'onde situé dans le domaine des UV et de la durée de la photactivation du photocatalyseur. Une trop faible intensité de lumière UV sur une trop courte durée, peut également empêcher la surface d'avoir des caractéristiques hydrophiles suffisante à un moment qui exigerait pourtant des propriétés antibuée efficace. Pour être plus précis, la notion de photocatalyse est étroitement associée au matériau dioxyde de titane sous sa variété cristallographique anatase. Le $TiO_2$ est un semi-conducteur apte, sous l'effet d'un rayonnement de longueur d'onde adéquate, à activer des réactions radicalaires provoquant l'oxydation des produits organiques. Le $TiO_2$ possède un gap entre deux niveaux d'énergie d'environ 3.2 eV. Si bien que d'après la relation de Planck $E=hv$, seuls les photons possédant une longueur d'onde inférieure ou égale à 387 nm seront actifs dans la réaction de photo-oxydation catalytique. De telles radiations appartiennent au domaine du proche UV si bien que l'extension de la photocatalyse au domaine du visible reste pour l'instant limitée. D'un point de vue pratique, ces photocatalyseurs sont déposés avec une couche de silice d'environ 200 nm sur le matériau en verre.

On entend par « verre» un solide non cristallin (amorphe) présentant le phénomène de transition vitreuse. Un verre est généralement dur, fragile, souvent transparent et isolant électrique. Le plus souvent, le verre est constitué d'oxyde de silicium (silice $SiO_2$) et de fondants, le constituant principal pour la fabrication est le sable. Parmi tous les types de verre, le plus courant est le verre sodocalcique, obtenu principalement à partir de la silice, de la soude et de la chaux. En dessous de sa température de transition vitreuse, qui est très élevée, le verre se présente à l'état vitreux.

US 4,948,760 et US 6,300,641 décrivent des procédés de traitement d'un substrat en verre par un bombardement ionique.

Il en résulte un besoin de méthode de traitement de surface de matériaux en verres pour apporter des propriétés hydrophile, voire superhydrophiles (antibuée), résistante aux contraintes mécaniques, insensibles aux conditions de luminosité, efficace à tout moment qui l'exige, sur une très longue durée, de préférence selon des méthodes facilement industrialisables, de manière à pouvoir offrir de telles matériaux en verres en quantité significative et à des coûts raisonnables.

L'invention a pour but d'offrir une méthode traitement de matériau en verre peu onéreuse et permettant de traiter des surfaces répondant aux besoins de nombreuses applications.

L'invention propose ainsi un procédé de traitement selon la revendication 1 de manière à modifier les caractéristiques de surface du matériau en verre dans le sens d'une plus grande hydrophilie (une meilleure mouillabilité) qui se caractérise par un angle de contact d'une goutte d'eau inférieure à 45°, voire dans le sens d'une superhydrophilie qui se caractérise par un angle de contact d'une goutte d'eau inférieure à 20°, de préférence inférieure à 10°.

Le choix des ions et des conditions de bombardement de ces ions selon l'invention permet d'obtenir avantageusement une augmentation de l'hydrophilie du matériau en verre se traduisant par une réduction de l'angle de contact et une augmentation de l'énergie de surface du matériau en verre traité. Ces propriétés sont très importantes pour réduire la formation de buée sur un pare-brise d'automobile, des verres de lunettes, des lentilles ou des miroirs de dispositifs optiques, ou encore des verres pour le bâtiment. On désigne par propriété antibuée le comportement et la qualité d'un matériau en verre à retarder, réduire ou empêcher la formation d'un condensat d'humidité sous forme de buée.

De manière étonnante, les inventeurs ont pu constater que les plages choisies selon l'invention de tension d'accélération et de dose d'ions par unité de surface, permettent de sélectionner des conditions expérimentales où le renforcement de propriétés hydrophile vers une superhydrophilie (caractérisé par un angle de contact de goutte d'eau inférieure à 20°, voire à 10°) associée à des propriétés antibuée, est possible grâce à un bombardement ionique.

Cette superhydrophilie mise au service de propriétés antibuée peut également se révéler très intéressante pour augmenter l'énergie de surface d'une gaine optique d'une fibre optique, pour améliorer ainsi l'adhérence de la gaine de protection (en polymère) qui entoure la gaine optique.

On peut également rechercher des propriétés hydrophiles voire super-hydrophiles pour favoriser le glissement d'un piston élastomère dans le corps d'une seringue en verre.

En outre, ils ont pu constater que le procédé selon l'invention peut être mis en œuvre « à froid », notamment à température ambiante et qu'il convient que la température du matériau en verre demeure inférieure ou égale à la valeur de transition du matériau en verre durant la mise en œuvre du procédé. On peut ainsi éviter avantageusement que le matériau en verre subisse dans sa masse une modification cristallographique préjudiciable à ses propriétés mécanique.

Le choix de la dose d'ions par unité de surface dans la plage de dose selon l'invention peut résulter d'une étape préalable d'étalonnage où on bombarde avec un des ions parmi N, O un échantillon constitué du matériau en verre envisagé. Le bombardement de ce matériau en verre peut s'effectuer dans différentes zones du matériau avec une pluralité de doses d'ions, dans la plage selon l'invention, et on observe les zones traitées de manière à choisir une dose adéquate en fonction de l'angle de contact d'une goutte d'eau avec le matériau en verre ou encore l'angle de décrochage minimal de cette même goutte obtenu en inclinant l'échantillon par rapport à un plan horizontal. Au delà de cet angle de décrochage minimal la goutte d'eau glisse, s'agrège sur son parcours aux autres gouttelettes, entrainant et évacuant avec elle le condensat d'humidité constituant la buée.

L'observation des zones traitées ainsi peut s'effectuer par des techniques d'observation simples, telles qu'une photographie de la goutte prise dans le plan du matériau en verre placé sur une table, ou encore le relevé de l'angle d'inclinaison à partir duquel la goutte se déplace sur le matériau en verre.

Sans vouloir être lié par une quelconque théorie scientifique, on peut penser que ce phénomène peut s'expliquer par la nature des liaisons chimiques créées par l'ion incident dans le matériau en verre. L'ion incident se recombine avec le silicium préférentiellement sous forme d'oxyde de silicium, de nitrure de silicium, formant des liaisons fortement polarisées propices à l'augmentation de l'énergie de surface. D'ou une augmentation du caractère polaire initial. De manière étonnante, les inventeurs ont pu constater que la surface du matériau prend alors un caractère polaire autrement dit hydrophile qui peut être exacerbé selon la dose et l'énergie d'implantation au point de devenir superhydrophile (angle de contact d'une goutte d'eau inférieur à 20°, voire à 10°).

Outre le renforcement des propriétés super-hydrophile associées aux propriétés antibuée indépendant des conditions d'exposition lumineuse, le procédé de l'invention permet de durcir la surface du matériau en verre sur une épaisseur de l'ordre du micron. Le procédé de l'invention présente ainsi l'avantage d'augmenter la résistance des surfaces aux contraintes mécaniques du milieu.

Le matériau en verre est prétraité avec des ions nobles comme Ar, Kr, Xe. Ce prétraitement a pour effet par un mécanisme de pulvérisation atomique préférentielle, d'appauvrir la zone d'implantation d'environs 200 nm d'épaisseur, en ions alcalins comme le sodium (Na), créant ainsi une zone de déplétion. Cette zone de déplétion a pour caractéristique d'être moins réactive aux processus lixiviants.

Selon ce dernier mode de réalisation, le matériau en verre sodocalcique est traité préalablement par des ions nobles lourds appartenant à la liste des éléments constituée de l'argon (Ar), du krypton (Kr), du xénon (Xe). Ce traitement préalable a pour fonction de créer une zone de déplétion en sodium (Na) favorable à la réduction du phénomène de lixiviation du verre. On rappelle en effet, qu'un verre d'oxyde présente en général une bonne résistance à la corrosion. On peut néanmoins modifier le processus d'altération du verre en soumettant celui-ci à des bains de pH différents. Dans le cas d'une solution lixiviante acide, un mécanisme d'échange ionique (alcalin / espèce hydrogénée) se produit alors entre le verre et le bain. Il se forme ainsi, à la surface du verre, une pellicule d'altération constituée de la couche dés alcalinisée. Cette couche est caractérisée par un indice de réfraction inférieur à celui du verre sain sous-jacent. La diminution de l'indice est liée, d'une part au départ d'ions alcalins du verre, mais aussi à l'apparition de pores. Ces volumes correspondent aux cavités laissées dans la matrice par le départ de ces ions. Le phénomène de lixiviation ce traduit par un blanchiment du verre. Une réduction de la présence du sodium en surface se traduit par une réduction de l'apparition de pores.

Les inventeurs ont procédé à des essais de corrosion par pesée micro-gravimétrique (différence de poids avant et après immersion), d'échantillons en verre sodocalcique vierge et traités, en les immergeant dans une solution d'acide chlorhydrique (HCl) avec un pH = 1, à température ambiante (20°C) selon différentes durées d'immersion. Les échantillons ont été traités selon deux doses $10^{16}$ et $10^{17}$ ions/cm$^2$ avec un faisceau d'ions argon (Argon) multichargés $Ar^+$, $Ar^{2+}$, $Ar^{3+}$, $Ar^{4+}$, $Ar^{5+}$ dont les intensités respectives sont 2, 1,29, 0,6, 0,22 et 0,11 mA. Ces ions multichargés ont été extraits avec une tension de 40 kV (kilovolts). La composition stœchiométrique superficielle du verre en silicium(Si), oxygène (0) et sodium (Na) avant et après traitement et avant immersion dans l'acide chlorhydrique (HCl) a été analysée par XPS(X-ray Photoelectron Spectroscopie). Ces résultats sont consignés dans le tableau a. Avant chaque pesée les échantillons immergés dans l'acide chlorhydrique (HCl) ont été lavés à l'eau distillée puis séchés.

Tableau a

|  | vierge | $10^{16}$ ions Ar/cm$^2$ | $10^{17}$ ions Ar/cm$^2$ |
|---|---|---|---|
| O | 45,22% | 47,11 | 49,36% |
| Si | 17,12% | 18,32 | 25,09% |
| Na | 6,13% | 3,69 | 0,92 % |

Les résultats obtenus par XPS mettent en évidence sous l'effet du traitement par bombardement ionique avec l'argon (Ar) l'appauvrissement superficiel en sodium (Na) dont la concentration passe de 6,13% à 3,69% puis à 0,92%.

Les inventeurs ont consigné dans le tableau b, pour le même verre vierge et traités selon deux doses $10^{16}$ et $10^{17}$ (ions Ar/cm$^2$) et d'un seul coté, les masses des échantillons exprimées en gramme, selon différentes durées d'immersion dans la solution HCl exprimées en jour. La microbalance a une précision de 100 microgrammes.

Tableau b

| Durée d'immersion | 0 jours | 1 jour | 4 jours |
|---|---|---|---|
| vierge | 3,7069 | 3,7068 | 3,7067 |
| $10^{16}$ (ions Ar/cm$^2$) | 3,8812 | 3,8812 | 3,8811 |
| $10^{17}$ (ions Ar/cm$^2$) | 3,9523 | 3,9523 | 3,9523 |

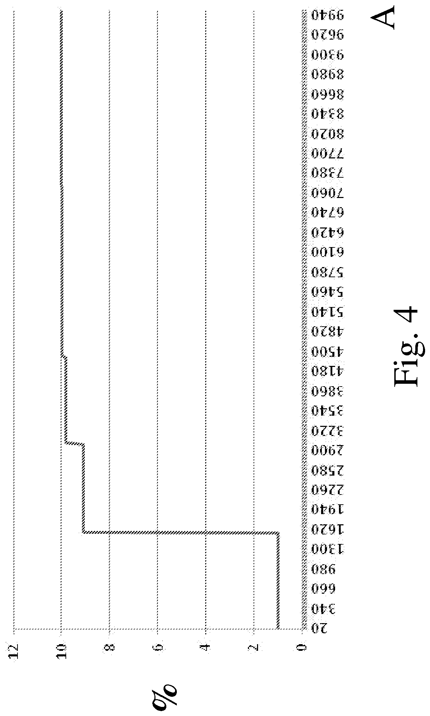

Sur la base de ces résultats il apparait que la vitesse de corrosion correspondant à la perte de masse est plus faible pour le verre traité que le verre vierge. Il existe donc bien une corrélation entre l'appauvrissement en sodium (Na) et l'augmentation de la résistance à la corrosion. La figure 4 représente cette tendance sur une période de plus de 30 jours.

Les inventeurs ont cherché à extrapoler ces résultats expérimentaux à tout type d'ions lourds comme le krypton (Kr) et le Xénon (Xe). Pour évaluer approximativement l'évolution et les tendances de l'appauvrissement en métaux alcalins (sodium), la forme et l'étendue de cette zone de déplétion, les inventeurs ont développé une modélisation semi-empirique s'appuyant à la fois sur le taux de pulvérisation massique moyen d'un verre sodocalcique mesurée expérimentalement par perte de masse (pesées micro-gravimétriques effectuées avant et après bombardement d'un échantillon) et sur des données expérimentales relatives aux taux de pulvérisation associés aux différentes espèces atomiques entrant dans la composition du verre en fonction du type d'ion, de leur énergie et de la dose reçue (données compilées dans l'ouvrage de « Stopping and Range Ions in Matter » (SRIM) de James Ziegler). Dans cette modélisation les inventeurs ont intégré le fait que les atomes pulvérisés hors du verre proviennent tous de la zone de parcours de l'ion incident dans le verre et que lorsqu'on atteint un régime de pulvérisation stationnaire (épaisseur pulvérisée supérieure à l'épaisseur de parcours de l'ion) on retrouve les taux de pulvérisation expérimentaux associés à chacun des composants atomiques entrant dans la composition du verre. Grace à cette modélisation les inventeurs ont pu mettre en évidence, qu'avant d'atteindre le régime de pulvérisation stationnaire, se dessine progressivement une zone de déplétion ou entrent en compétition, un mécanisme d'appauvrissement sodocalcique (expulsion préférentielle par pulvérisation des ions sodium) dont les effets sont peu à peu effacés par une pulvérisation massique globale du verre. Lorsque le régime stationnaire est atteint, le profil de concentration en ions alcalins se stabilise pour donner des concentrations inférieures aux concentrations initiales.

En utilisant cette modélisation semi-empirique et en se basant sur une composition stœchiométrique initiale moyenne du verre sodocalcique donnée dans le tableau c, les inventeurs ont obtenu pour ce verre sodocalcique bombardé avec des ions lourds Ar, Xe, selon 3 énergies différentes (20, 40 et 60 keV) et pour différentes doses, les résultats estimatifs suivants :

Tableau c

| Composition stoechiométrique initiale du verre sodocalcique (en %) | |
|---|---|
| O | 60 |
| Si | 25 |
| Na | 10 |
| Ca | 3 |
| Mg | 1 |
| Al | 1 |
| Total | 100 |

Tableau d

| | Composition stœchiométrique estimée en Na (Sodium) | | | | | |
|---|---|---|---|---|---|---|
| | Après Bombardement avec Ar | | | Après bombardement avec Xe | | |
| Dose (ions/cm2) | 20 keV | 40 keV | 60 keV | 20 keV | 40 keV | 60 keV |
| 0 | 10 % | | | | | |
| $10^{16}$ | 9,6% | 9,72% | 9,8% | 8% | 8,8% | 8,8% |
| 2. $10^{16}$ | 9,3% | 9,4% | 9,8% | 3% | 6,5% | 7 % |
| 5.$10^{16}$ | 7% | 8% | 8,8% | ~0 | ~0 | 0 |
| $10^{17}$ | ~0% | 5,5% | 7,2% | ~0 | ~0 | ~0 |
| 2.$10^{17}$ | ~0% | ~0 | 1% | ~0 | ~0 | ~0 |
| $10^{18}$ | ~0% | ~0 | ~0 | ~0 | ~0 | ~0 |

De ce modèle semi-empirique, il ressort globalement du tableau d, que pour des énergies comprises entre 10 et 100 keV on doit pouvoir obtenir un appauvrissement important en ions sodium (Na), donc un renforcement de la résistance à la lixiviation, en choisissant une dose située :

- De préférence entre 5.$10^{16}$ et 5.$10^{17}$ ions/cm$^2$ pour un bombardement à l'argon (Ar)

- De préférence entre 5.$10^{15}$ et 5.$10^{16}$ ions/cm$^2$ pour un bombardement au xénon (Xe)

- Par extrapolation, on donnera une plage comprise entre $10^{16}$ et $10^{17}$ ions/cm$^2$ pour le krypton (Kr)

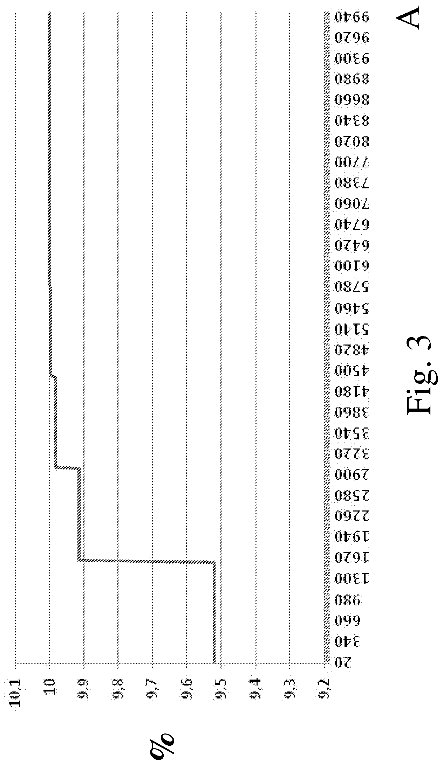

Les inventeurs ont extrapolé ce modèle semi-empirique pour des faisceaux réels d'ions multichargés en cumulant les effets obtenus pour des ions argon Ar+ multi-énergies. Pour un faisceau d'ions constitué d'ions multichargés Ar$^+$, Ar$^{2+}$, Ar$^{3+}$, Ar$^{4+}$, Ar$^{5+}$ dont les intensités respectives sont 2, 1,29, 0,6, 0,22 et 0,11 mA, extraits avec une tension de 35 kV (kilovolts) et dont les énergies respectives sont 35, 70, 105, 140 et 175 keV (kilo-électron-Volt) les inventeurs ont pu estimer les concentrations en ions alcalins Na selon 2 doses d'implantation 1,7x$10^{16}$ et 1,7x$10^{17}$ ions/cm$^2$. Les figures 3 et 4 représentent le profil en concentration atomique en sodium (Na) après un bombardement avec ce faisceau d'ions argon (Ar) selon une dose respective de 1,7x$10^{16}$ et 1,7x$10^{17}$ ions/cm$^2$. Le profil de concentration présente une série de paliers indiquant les limites de pénétration des ions argon des moins énergétiques (Ar+) au plus énergétiques (Ar5+). Les abscisses correspondent à la profondeur exprimée en Angstrœm (A), les ordonnées à la concentration atomique (%) . On constate que pour une dose $1,7 \times 10^{17}$ ions/$cm^2$ la concentration en sodium (Na) est fortement abaissée, passant d'un taux initial de 10% à un taux résiduel de 2% sur une profondeur d'environs 0,16 microns. On peut constater que ces résultats semi-empiriques sont globalement validés expérimentalement par les résultats obtenus par analyse XPS. On rappelle que pour une dose d'environs $10^{17}$ ions Ar/$cm^2$ extraite à 35 kV (kilovolt) la concentration résiduelle en sodium (Na) mesurée expérimentalement par XPS est égale à 0,92% pour une concentration initiale de 6,13%, à comparer à la concentration résiduelle de 2% prédite par le modèle semi-empirique pour une concentration initiale de 10%. Ces résultats valident ainsi le choix des plages de doses obtenues et conseillées par les inventeurs pour le krypton (Kr) et le Xénon (Xe) pour pouvoir réduire de façon appréciable la concentration en sodium (Na) et augmenter la résistance à la corrosion.

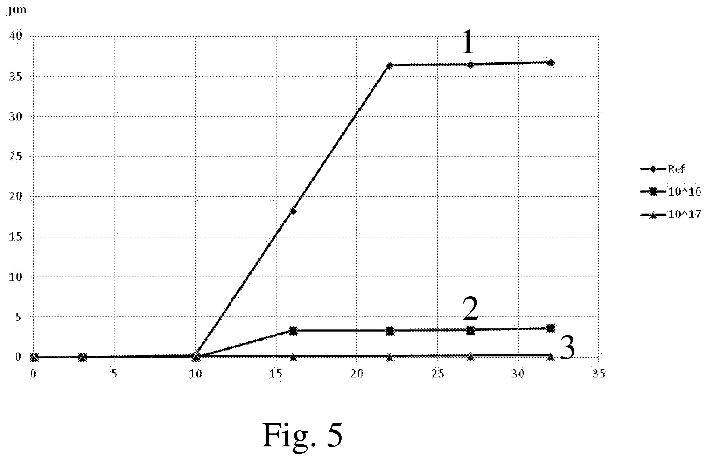

La figure 5 représente l'évolution sur une longue durée de plus de 30 jours de l'épaisseur corrodée de 3 échantillons carrés (2 x 2 cm, de 0,4 cm d'épaisseur) : un des échantillons est un échantillon de référence n'ayant fait l'objet d'aucun traitement, 2 échantillons ont été traités sur une seule face avec des ions argon (Ar) d'une énergie de 40 keV selon deux doses respectives égales $10^{16}$ et $10^{17}$ ions Ar/$cm^2$. Ces échantillons de verre ont été immergés dans la même solution HCl, pH = 1 à température ambiante (25°C). L'épaisseur corrodée en a été évaluée à partir des mesures de perte de masse. L'axe des abscisses représente la durée d'immersion exprimée en jours, l'axe des ordonnées représente l'épaisseur corrodée exprimée en micromètre (pm). On constate que la résistance à la corrosion de l'échantillon traité avec une dose de $10^{17}$ ions Ar/$cm^2$ est supérieure à celle de l'échantillon traité avec une dose de $10^{16}$ ions Ar/$cm^2$ qui est elle-même supérieure à celle de l'échantillon de référence.

Renforcer la résistance à la lixiviation du verre par traitement préalable avec des ions lourds ne peut que favoriser une augmentation de la durabilité de la superhydrophilie obtenu par un traitement avec des ions azote (N) ou oxygène (0). Pour permettre la création d'une couche super-hydrophile de très longue durée, les inventeurs préconisent donc ce prétraitement par bombardement avec des ions lourds Ar, Kr, Xe dans les plages de doses indiquées ci-dessus, en vue de réduire la réactivité de la surface à tout processus lixiviant.

Selon différents modes de réalisation du procédé de traitement de l'invention pour augmenter les propriétés hydrophile d'un matériau en verre, qui peuvent être combinés entre eux:

- la dose d'ions par unité de surface est comprise entre $10^{15}$ ions/$cm^2$ et $10^{18}$ ions/$cm^2$ ; selon un mode de réalisation, la dose d'ions par unité de surface est comprise entre $10^{15}$ ions/$cm^2$ et $10^{17}$ ions/$cm^2$ ; selon un mode de réalisation, la dose d'ions par unité de surface est comprise entre $5.10^{15}$ ions/$cm^2$ et $10^{18}$ ions/$cm^2$ ;

- la tension d'accélération des ions est comprise entre 5 kV et 200 kV ; selon un mode de réalisation, la tension d'accélération des ions est comprise entre 10 kV et 100 kV ; la tension d'accélération des ions est comprise entre 10 kV et 50 kV ; la tension d'accélération des ions est comprise entre 20 kV et 40 kV ;

- on détermine la dose d'ions par unité de surface et la tension d'accélération des ions de manière à ce que la concentration atomique superficielle est supérieure ou égale à un seuil de concentration atomique de 0,1% pour l'azote et à un seuil de concentration atomique de 2,5% pour l'oxygène;

- les ions du faisceau d'ions sont de l'azote (N), la tension d'accélération TA est supérieure ou égale à 10 kV et la dose d'ions par unité de surface est supérieure ou égale à une valeur DNmin = $(TA/20)^2$, où DNmin est exprimée en $10^{16}$ ions/$cm^2$ et la tension d'accélération TA est exprimée en kV ou bien les ions du faisceau d'ions sont de l'oxygène (0), la tension d'accélération TA est supérieure ou égale à 10 kV et la dose d'ions par unité de surface est supérieure ou égale à une valeur DOmin = $10.(TA/20)^{1,5}$, où DOmin est exprimée en $10^{16}$ ions/$cm^2$ et la tension d'accélération TA est exprimée en kV ;

- les ions sont produits par une source à résonance cyclotronique électronique (RCE) qui produit des ions multichargés et a l'avantage d'être compacte et économe en énergie ;

- le matériau en verre est choisi parmi la liste des verres sodocalciques.

Selon un mode de réalisation, la dose d'ions par unité de surface est comprise entre $10^{15}$ ions/$cm^2$ et $10^{17}$ ions/$cm^2$ et la tension d'accélération des ions est comprise entre 10 kV et 50 kV, par exemple entre 20 kV et 40 kV.

Selon un mode de réalisation, le procédé de traitement hydrophile l'invention comprend une étape préalable où l'on détermine la dose d'ions par unité de surface et la tension d'accélération des ions selon les étapes suivantes :

a. on choisit une tension d'accélération des ions comprise entre 10 kV et 100 kV ;

b. on choisit une dose d'ions par unité de surface est comprise entre $10^{15}$ ions/$cm^2$ et $10^{17}$ ions/$cm^2$ ;

c. on effectue un traitement selon l'invention dans les conditions choisies ;

d. on mesure l'angle de contact d'une goutte d'eau inférieure sur le matériau en verre ainsi traité ;

e. on compare l'angle de contact mesuré avec une valeur désirée d'angle de contact ;

f. si l'angle de contact mesuré est supérieur à la valeur désirée d'angle de contact, on effectue à nouveau un traitement selon l'invention avec une dose d'ions par unité de surface double de celle précédemment utilisée ;

g. on répète les étapes c à f jusqu'à déterminer la dose d'ions par unité de surface et la tension d'accélération des ions pour obtenir un angle de contact mesuré inférieur ou égal à la valeur désirée d'angle de contact.

Selon un mode de réalisation, la valeur désirée d'angle de contact est inférieure ou égale 20°, par exemple égale à 20° ou égale à 15° ou égale à 10°.

D'autres particularités et avantages de la présente invention ressortiront dans la description ci-après d'exemples de réalisation non limitatifs.

Selon des exemples de mise en œuvre de la présente invention, des échantillons de matériau en verres sodocalciques ont fait l'objet d'études, avec des ions azote pour certains échantillons et avec des ions d'oxygène pour d'autres échantillons. Ces ions ont été émis par une source RCE. La famille des verres sodocalciques (« Soda-lime glass » pour les anglophones) regroupe des verres à base de silice $SiO_2$, de calcium et de sodium introduits en général à la fabrication sous forme de CaO et $Na_2O$. Ces verres sont les plus répandus ; ils sont utilisés pour la fabrication de bouteilles, de flacon et de vitrages, et représentent de l'ordre de 90% de la production de verre.

Le faisceau d'ions d'azote d'une intensité de 1 mA comprend des ions $N^+$, $N^{2+}$, $N^{3+}$; la tension d'extraction et d'accélération est de 20 kV ; l'énergie de N+ est de 20 keV et celle de $N^{2+}$ de 40 keV, $N^{3+}$ de 60 keV.

Le faisceau d'ions d'oxygène 'une intensité de 1 mA comprend des ions $O^+$, $O^{2+}$, $O^{3+}$; la tension d'extraction et d'accélération est de 20 kV ; l'énergie de O+ est de 20 keV et celle de $O^{2+}$ de 40 keV, $O^{3+}$ de 60 keV.

L'échantillon à traiter se déplace par rapport au faisceau avec une vitesse de déplacement à 120 mm/s avec un pas d'avancement latéral à chaque retour de 4 mm (10% du diamètre faisceau qui mesure 40 mm). Pour atteindre la dose nécessaire le traitement se fait en plusieurs passes.

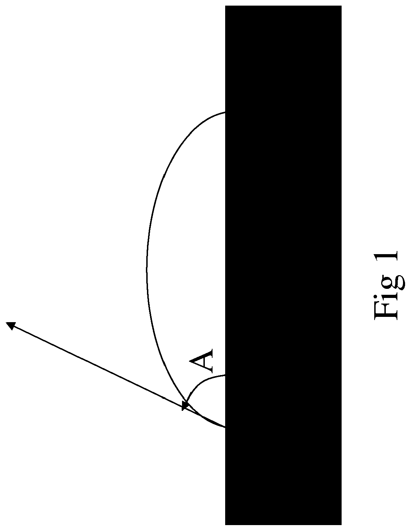

L'hydrophilie de la surface, peut être évaluée en déposant une goutte d'eau sur la surface. La figure 1 représente une goutte de d'eau en équilibre sur une surface plane. Il est possible en mesurant l'angle de contact(A) de quantifier l'hydrophilie de la surface avec l'eau. Plus l'angle de contact est faible, plus l'hydrophilie de la surface est élevée. Lorsque l'angle de contact est inférieur à 20°, par exemple à 10°, la surface est superhydrophile. Si l'angle de contact est supérieur à 90°, la surface est hydrophobe.

Des tests ont été faits en déposant des gouttes d'eau sur les surfaces traitées par le procédé de l'invention pour des doses correspondant à $10^{15}$, $10^{16}$ et $10^{17}$ ions/cm$^2$ avec une tension d'accélération de 20 kV. Les tableaux 1 et 2 donnent les valeurs des angles de contact des gouttes d'eau déposées sur le matériau en verre traité respectivement avec des ions d'azote et des ions oxygène selon le procédé de l'invention avec différentes doses.

Des tests ont également été faits en déposant des gouttes d'eau sur les surfaces traitées par le procédé de l'invention avec des ions d'azote pour des doses correspondant à $10^{15}$, $10^{16}$ et $10^{17}$ ions/cm$^2$ avec une tension d'accélération de 35 kV et sont reportés dans la deuxième partie du tableau 1.

Tableau 1 : azote

| Verre | vierge | $10^{15}$ ions/cm$^2$ à 20 kV | $10^{16}$ ions/cm$^2$ à 20 kV | $10^{17}$ ions/cm$^2$ à 20 kV |
|---|---|---|---|---|
| Angle de contact(°) | 62 | 34 | 9 à 12 | 5 |
| Verre | vierge | $10^{15}$ ions/cm$^2$ à 35 kV | $10^{16}$ ions/cm$^2$ à 35 kV | $10^{17}$ ions/cm$^2$ à 35 kV |
| Angle de contact(°) | 62 | 61 | 56 | 40 |

Tableau 2 : oxygène

| Verre | vierge | $10^{15}$ ions/cm$^2$ à 20 kV | $10^{16}$ ions/cm$^2$ à 20 kV | $10^{17}$ ions/cm$^2$ à 20 kV |
|---|---|---|---|---|
| Angle de contact(°) | 62 | 43 | 29 | 10 |

On constate que des propriétés hydrophiles sont obtenues avec l'azote ou l'oxygène dès $10^{15}$ ions/cm$^2$ pour

une tension d'accélération de 20 kV. On constate que des propriétés hydrophiles sont obtenues avec l'azote à partir de $10^{17}$ ions/cm$^2$ pour une tension d'accélération de 35 kV. L'angle de contact décroit avec la dose. Pour une même dose l'azote est plus efficace que l'oxygène pour créer des propriétés superhydrophiles (angle de contact inférieur à 20°, notamment à 10°). Pour une tension d'accélération de 20 kV, et pour l'azote on observe clairement des propriétés superhydrophiles à partir d'une dose d'environ $10^{16}$ ions/ cm$^2$, pour l'oxygène avec une même tension d'accélération, il faut atteindre une dose environ dix fois supérieure de $10^{17}$ ions/cm$^2$. On passe ainsi pour un matériau en verre sodocalcique d'un comportement hydrophile à un comportement superhydrophile qui est notamment associé à des propriétés antibuée.

Les inventeurs démontrent ainsi qu'il existe une gamme de doses possibles pour atteindre un caractère super-hydrophile. La dose minimale obtenue par cette étude est $10^{16}$ ions/cm$^2$ pour l'azote et $10^{17}$ ions/cm$^2$ pour l'oxygène et pour une tension d'accélération de 20 kV. Les inventeurs estiment que globalement la plage de dose pour atteindre des propriétés hydrophiles appréciables (angle de contact d'une goutte d'eau inférieur ou égal à 20°) est comprise approximativement entre $5 \times 10^{15}$ ions/cm$^2$ et $10^{18}$ ions/cm$^2$ pour une tension d'accélération de 20 kV.

Les inventeurs ont par ailleurs pu constater que pour une tension d'accélération plus importante égale à 35 kV, les doses requises pour obtenir les propriétés de super-hydrophiles (angle de contact d'une goute d'eau inférieur à 10°) sont plus importantes, environs 3 fois supérieurs à celle requise pour une tension de 20 kV, aussi bien pour l'azote que pour l'oxygène. Pour l'azote la dose est d'environs $3 \times 10^{16}$ ions/cm2 et pour l'oxygène la dose est d'environs $2,5 \times 10^{17}$ ions/cm2.

Pour une tension de 20 kV, les doses respectives $10^{16}$ en ions azote/cm$^2$ et $10^{17}$ ions oxygène/cm$^2$ correspondent après calcul à une concentration atomique superficielle en ions implantés d'environs 0,1% pour l'azote et 2,5% pour l'oxygène.

Pour une tension de 35 kV, les doses respectives $3 \times 10^{16}$ en ions azote/cm$^2$ et $3 \times 10^{17}$ ions oxygène/cm$^2$ correspondent après calcul à une concentration atomique superficielle (en extrême surface) en ions implantés d'environs 0,1% pour l'azote et 2,5% pour l'oxygène pour une tension.

Sur la base de ces résultats expérimentaux, les inventeurs ont estimé par calcul, que la concentration atomique superficielle doit dépasser un seuil de concentration atomique d'environs 0,1% pour l'azote et 2,5% pour l'oxygène pour obtenir un effet de superhydrophilie. En s'appuyant sur cette concentration atomique seuil à partir de laquelle ces propriétés super-hydrophiles apparaissent, les inventeurs ont pu calculer par extrapolation pour une tension d'accélération donnée, la dose minimale requise pour obtenir ces propriétés super-hydrophiles. Ces résultats sont consignés dans le tableau ci-dessous pour l'azote et l'oxygène:

Pour l'azote on obtient par extrapolation les résultats suivants:

| Tension accélération (kV) | 10 | 20 | 30 | 40 | 50 |
|---|---|---|---|---|---|
| Dose minimale requise ($10^{16}$ ions/cm$^2$) | 0,15 | 1 | 2 | 3,6 | 8,8 |

Pour une tension d'accélération supérieure à 10 kV, on peut extraire de ce tableau, la formule empirique reliant la dose minimale d'ions azote DNmin exprimée en $10^{16}$ ions/cm2 à la tension d'accélération TA) exprimée en kV:

$$DNmin = (TA/20)^2.$$

Pour l'oxygène on obtient par extrapolation les résultats suivants

| Tension accélération (kV) | 10 | 20 | 30 | 40 | 50 |
|---|---|---|---|---|---|
| Dose minimale requise ($10^{16}$ ions/cm$^2$) | 2,25 | 10 | 17 | 28 | 41 |

Pour une tension d'accélération supérieure à 10 kV, on peut extraire de ce tableau, la formule reliant la dose minimale d'ions oxygène DOmin exprimée en $10^{16}$ ions/cm$^2$ à la tension d'accélération TA exprimée en kV:

$$DOmin = 10.(TA/20)^{1,5}$$

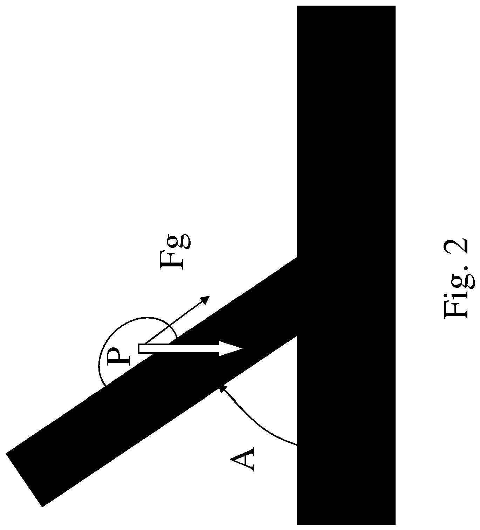

La capacité d'une surface à évacuer l'eau, donc la buée, peut être évaluées en mesurant l'angle de décrochage de la goutte sur la surface. La figure 2 représente un dispositif permettant la mesure de l'angle de décrochage. La goutte est placée sur un échantillon dont on peut faire varier l'angle d'inclinaison par rapport au plan horizontal On augmente très progressivement l'angle (A). Le poids P de la goutte se transforme en une force tangentielle Fg qui a pour effet de faire glisser la goutte sur le plan incliné lorsque l'angle (A) est supérieur à un angle de décrochage minimal qui est caractéristique de la capacité à évacuer l'eau sur l'échantillon.

Les résultats sont synthétisés dans les tableaux 3 et 4 respectivement pour l'azote et l'oxygène avec des faisceaux d'ions dont les caractéristiques sont celles indiquées ci-dessus.

Tableau 3

| Doses estimées ($10^{16}$ions N /cm$^2$) | Angle de décrochage minimal (°) |
|---|---|
| 0 | 55 |
| 0.1 | 33 |
| 1 | 25 |
| 10 | 15 |

Tableau 4

| Doses estimées ($10^{16}$ions 0 /cm$^2$) | Angle de décrochage minimal (°) |
|---|---|
| 0 | 55 |
| 0.1 | 48 |
| 1 | 32 |
| 10 | 20 |

On constate que les échantillons traités selon le procédé de l'invention présentent des angles de décrochage inférieurs de 40° à l'angle de décrochage de l'échantillon vierge pour l'azote et de 35° pour l'oxygène. Cela signifie que la force nécessaire pour faire glisser la goutte d'eau est plus faible. Cette force de glissement Fg correspond au poids de P de la goutte projeté sur le plan de glissement : Fg = P x sin(A). On appliquant cette règle on estime que la force de glissement de la goutte pour l'échantillon vierge est égale à P.sin (55°) et pour une dose de $10^{17}$ ions/cm$^2$ égale à P.sin (15°), soit une diminution de l'adhérence d'un facteur 70% de la goutte sur le matériau en verre traité.

Selon différents modes de réalisation du procédé selon la présente invention, qui peuvent être combinés entre eux :

- le matériau en verre est mobile par rapport au faisceau d'ions à une vitesse, $V_D$, comprise entre 0,1 mm/s et 1000 mm/s. Il est ainsi possible de déplacer l'échantillon pour traiter des zones dont la dimension est supérieure à celle du faisceau. La vitesse de défilement $V_D$, peut être constante ou variable. Selon un mode de réalisation, le matériau en verre se déplace et le faisceau d'ions est fixe. Selon un autre mode de réalisation, le faisceau d'ions balaie le matériau en verre. Il est également possible que le matériau en verre se déplace quand le faisceau d'ions est mobile. Selon un mode de réalisation, une même zone du matériau en verre est déplacée sous le faisceau d'ions selon une pluralité, N, de passages à la vitesse $V_D$. Il est ainsi possible de traiter une même zone du matériau en verre avec une dose d'ions correspondant à la somme des doses d'ions reçues par cette zone à l'issue des N passages. On note également que si la taille du matériau en verre le permet, l'étape de traitement peut être statique et résulter d'un ou plusieurs « flash » d'ions ;

Les surfaces superhydrophiles traitées selon le procédé de l'invention présentent ainsi un triple avantage:

• D'inhiber la formation de la buée indépendamment des conditions de luminosité, sur une longue durée.

• Provoquer un meilleur étalement des gouttelettes qui fusionnent en un film d'eau qui s'évapore plus rapidement.

• D'évacuer plus rapidement les gouttelettes situées sur des plans faiblement inclinés

**Revendications**

1.  Procédé de traitement pour augmenter les propriétés hydrophile d'un matériau en verre sodocalcique, ledit procédé consistant en un bombardement ionique où :

    - les ions du faisceau d'ions sont sélectionnés parmi les ions des éléments de la liste constituée de l'azote (N), de l'oxygène (0);
    - la tension d'accélération, TA, des ions est supérieure ou égale à 5 kV et inférieure ou égale à 1000 kV , notamment supérieure ou égale à 5 kV et inférieure ou égale à 200 kV, voire supérieure ou égale à 10 kV et inférieure ou égale 100 kV ;
    - la température du matériau en verre sodocalcique est inférieure ou égale à la température de transition vitreuse;
    - la dose d'ions par unité de surface est située dans une plage comprise entre $10^{12}$ ions/cm$^2$ et $10^{18}$ ions/cm$^2$, notamment supérieure ou égale à $10^{15}$ ions/cm$^2$, voire supérieure ou égale à $10^{15}$ ions/cm$^2$ et inférieure ou égale à $10^{17}$ ions/cm$^2$,

    le procédé étant **caractérisé en ce que** le matériau en verre sodocalcique fait l'objet d'un prétraitement, pour renforcer durablement du traitement hydrophile ci-dessus, consistant en un bombardement ionique où :

    - les ions du faisceau d'ions sont sélectionnés parmi les ions des éléments de la liste constituée de l'argon(Ar), du krypton(Kr), du xénon (Xe);
    - la tension d'accélération des ions est supérieure ou égale à 5 kV et inférieure ou égale à 1000 kV ;
    - la température du matériau en verre sodocalcique est inférieure ou égale à la température de transition vitreuse;
    - on choisit la dose d'ions par unité de surface dans une plage comprise entre $10^{12}$ ions/cm$^2$ et $10^{18}$ ions/cm$^2$.

2.  Procédé selon la revendication 1, **caractérisé en ce que** la plage de dose pour les ions argons (Ar) est comprise entre $5 \times 10^{16}$ et $5 \times 10^{17}$ ions par cm2 pour renforcer durablement les propriétés hydrophiles.

3.  Procédé selon la revendication 1, **caractérisé en ce que** la plage de dose pour les ions krypton (Kr) est comprise entre $10^{16}$ et $10^{17}$ ions par cm$^2$ pour renforcer durablement les propriétés hydrophiles.

4.  Procédé selon la revendication 1, **caractérisé en ce que** la plage de dose pour les ions xénon (Xe) est comprise entre $5 \times 10^{15}$ et $5 \times 10^{16}$ ions par cm$^2$ pour renforcer durablement les propriétés hydrophiles.

5.  Procédé selon la revendication 1, **caractérisé en ce que** la dose d'ions d'azote ou d'oxygène par unité de surface est choisie dans une plage comprise entre $5 \times 10^{15}$ ions/cm$^2$ et $10^{18}$ ions/cm$^2$ pour réduire l'angle de contact d'une goutte d'eau en deçà d'une valeur inférieure ou égale à 20°.

6.  Procédé selon l'une quelconque des revendications précédentes, **caractérisé en ce que**, pour les ions d'argon ou d'oxygène, l'on détermine la dose d'ions par unité de surface et la tension d'accélération desdits ions de manière à ce que la concentration atomique superficielle est supérieure ou égale à un seuil de concentration atomique de 0,1% pour l'azote, et à un seuil de concentration atomique de 2,5% pour l'oxygène.

7.  Procédé selon l'une quelconque des revendications 1 à 6, **caractérisé en ce que** les ions du faisceau d'ions sont de l'azote (N), la tension d'accélération TA est supérieure ou égale à 10 kV et la dose d'ions d'azote par unité de surface est supérieure ou égale à une valeur DNmin = $(TA/20)^2$, où DNmin est exprimée en $10^{16}$ ions/cm$^2$ et la tension d'accélération TA est exprimée en kV.

8.  Procédé selon l'une quelconque des revendications 1 à 6, **caractérisé en ce que** les ions du faisceau d'ions sont de l'oxygène (0), la tension d'accélération TA est supérieure ou égale à 10 kV et la dose d'ions d'oxygène par unité de surface est supérieure ou égale à une valeur DOmin = $10.(TA/20)^{1,5}$, où DOmin est exprimée en $10^{16}$ ions/cm$^2$ et la tension d'accélération TA est exprimée en kV.

9.  Procédé selon l'une quelconque des revendications précédentes, **caractérisé en ce qu'**il comprend une étape préalable où l'on détermine la dose d'ions d'azote ou d'oxygène par unité de surface et la tension d'accélération desdits ions selon les étapes suivantes :

    a. on choisit une tension d'accélération des ions comprise entre 10 kV et 100 kV ;
    b. on choisit une dose d'ions par unité de surface comprise entre $10^{15}$ ions/cm$^2$ et $10^{17}$ ions/cm$^2$ ;

c. on effectue un bombardement ionique dans les conditions choisies ;

d. on mesure l'angle de contact d'une goutte d'eau inférieure sur le matériau en verre sodocalcique ainsi traité ;

e. on compare l'angle de contact mesuré avec une valeur désirée d'angle de contact ;

f. si l'angle de contact mesuré est supérieur à la valeur désirée d'angle de contact, on effectue à nouveau un bombardement ionique avec une dose d'ions par unité de surface double de celle précédemment utilisée ;

g. on répète les étapes c à f jusqu'à déterminer la dose d'ions par unité de surface et la tension d'accélération des ions pour obtenir un angle de contact mesuré inférieur ou égal à la valeur désirée d'angle de contact.

10. Procédé selon l'une quelconque des revendications précédentes, **caractérisé en ce que** le matériau en verre sodocalcique est mobile par rapport au faisceau d'ions d'azote ou d'oxygène à une vitesse, $V_D$, comprise entre 0,1 mm/s et 1000 mm/s.

11. Procédé selon la revendication 10, **caractérisé en ce qu'**une même zone du matériau en verre sodocalcique est déplacée sous le faisceau d'ions d'azote ou d'oxygène selon une pluralité, N, de passages à la vitesse $V_D$.

12. Procédé selon l'une quelconque des revendications précédentes, utilisé pour traiter une pièce massive en verre sodocalcique choisie parmi la liste constituée d'un pare brise d'automobile, d'un verre de lunette, d'une lentille d'un dispositif optique, d'un miroir, d'une vitre d'un bâtiment, d'une fibre optique, d'un corps de seringue en verre.

13. Pièce en verre sodocalcique comprenant au moins une surface hydrophile traitée selon l'une quelconque des revendications précédentes.

**Patentansprüche**

1. Behandlungsverfahren zur Verstärkung der hydrophilen Eigenschaften eines Kalk-Natron-Glasmaterials, wobei das Verfahren aus Ionenbeschuss besteht, wobei :

- die Ionen des Ionenstrahls gewählt sind aus den Ionen der Elemente der Liste, umfassend Stickstoff (N) und Sauerstoff (O);
- die Beschleunigungsspannung TA der Ionen größer oder gleich 5 kV und kleiner oder gleich 1000 kV, insbesondere größer oder gleich 5 kV und kleiner oder gleich 200 kV, oder sogar größer oder gleich 10 kV und kleiner oder gleich 100 kV ist;
- die Temperatur des Kalk-Natron-Glasmaterials kleiner oder gleich der Glasübergangstemperatur ist;
- die Ionendosis pro Flächeneinheit in einem Bereich zwischen $10^{12}$ Ionen/$cm^2$ und $10^{18}$ Ionen/$cm^2$, insbesondere größer oder gleich $10^{15}$ Ionen/$cm^2$, oder größer oder gleich $10^{15}$ Ionen/$cm^2$ und kleiner oder gleich $10^{17}$ Ionen/$cm^2$ liegt,

wobei das Verfahren **dadurch gekennzeichnet ist, dass** das Kalk-Natron-Glasmaterial einer Vorbehandlung unterzogen wird, um die oben genannte hydrophile Behandlung, die aus einem Ionenbeschuss besteht, dauerhaft zu verstärken, wobei:

- die Ionen des Ionenstrahls gewählt sind aus den Ionen der Elemente der Liste, umfassend Argon (Ar), Krypton (Kr) und Xenon (Xe);
- die Beschleunigungsspannung der Ionen größer oder gleich 5 kV und kleiner oder gleich 1000 kV ist;
- die Temperatur des Kalk-Natron-Glasmaterials kleiner oder gleich der Glasübergangstemperatur ist;
- die Ionendosis pro Flächeneinheit in einem Bereich zwischen $10^{12}$ Ionen/$cm^2$ und $10^{18}$ Ionen/$cm^2$ gewählt ist.

2. Verfahren nach Anspruch 1, **dadurch gekennzeichnet, dass** der Dosisbereich für Argon (Ar)-Ionen zwischen $5 \times 10^{16}$ und $5 \times 10^{17}$ Ionen pro $cm^2$ liegt, um die hydrophilen Eigenschaften dauerhaft zu verstärken.

3. Verfahren nach Anspruch 1, **dadurch gekennzeichnet, dass** der Dosisbereich für Krypton (Kr)-Ionen zwischen $10^{16}$ und $10^{17}$ Ionen pro $cm^2$ liegt, um die hydrophilen Eigenschaften dauerhaft zu verstärken.

4. Verfahren nach Anspruch 1, **dadurch gekennzeichnet, dass** der Dosisbereich für Xenon-(Xe)-Ionen zwischen $5 \times 10^{15}$ und $5 \times 10^{16}$ Ionen pro $cm^2$ liegt, um die hydrophilen Eigenschaften dauerhaft zu verstärken.

5. Verfahren nach Anspruch 1, **dadurch gekennzeichnet, dass** die Dosis an Stickstoff- oder Sauerstoffionen pro Flächeneinheit in einem Bereich zwischen $5 \times 10^{15}$ Ionen/$cm^2$ und $10^{18}$ Ionen/$cm^2$ gewählt wird, um den Kontaktwinkel eines Wassertropfens auf einen Wert kleiner oder gleich 20° zu reduzieren.

**6.** Verfahren nach einem der vorhergehenden Ansprüche, **dadurch gekennzeichnet, dass** für Argon- oder Sauerstoffionen die Ionendosis pro Flächeneinheit und die Beschleunigungsspannung dieser Ionen so bestimmt werden, dass die atomare Oberflächenkonzentration größer oder gleich einer atomaren Konzentrationsschwelle von 0,1% für Stickstoff und einer atomaren Konzentrationsschwelle von 2,5% für Sauerstoff ist.

**7.** Verfahren nach einem der Ansprüche 1 bis 6, **dadurch gekennzeichnet, dass** die Ionen des Ionenstrahls Stickstoff (N) sind, die Beschleunigungsspannung TA größer oder gleich 10 kV ist und die Stickstoffionendosis pro Flächeneinheit größer oder gleich einem Wert DNmin $(TA/20)^2$ ist, wobei DNmin als $10^{16}$ Ionen/$cm^2$ angegeben ist und die Beschleunigungsspannung TA in kV angegeben ist.

**8.** Verfahren nach einem der Ansprüche 1 bis 6, **dadurch gekennzeichnet, dass** die Ionen des Ionenstrahls Sauerstoff (O) sind, die Beschleunigungsspannung TA größer oder gleich 10 kV ist und die Dosis der Sauerstoffionen pro Flächeneinheit größer oder gleich einem Wert DOmin = $10.(TA/20)^{1,5}$ ist, wobei DOmin als $10^{16}$ Ionen/$cm^2$ angegeben ist und die Beschleunigungsspannung TA in kV angegeben ist.

**9.** Verfahren nach einem der vorhergehenden Ansprüche, **dadurch gekennzeichnet, dass** es einen vorhergehenden Schritt umfasst, in dem die Dosis an Stickstoff- oder Sauerstoffionen pro Flächeneinheit und die Beschleunigungsspannung dieser Ionen gemäß den folgenden Schritten bestimmt wird:

a. es wird eine Ionenbeschleunigungsspannung zwischen 10 kV und 100 kV gewählt;
b. es wird eine Ionendosis pro Flächeneinheit zwischen $10^{15}$ Ionen/$cm^2$ und $10^{17}$ Ionen/$cm^2$ gewählt;
c. es wird ein Ionenbeschuss unter den gewählten Bedingungen durchgeführt;
d. der Kontaktwinkel eines unteren Wassertropfens auf dem so behandelten Kalk-Natron-Glasmaterial wird gemessen;
e. der gemessene Kontaktwinkel wird mit einem gewünschten Kontaktwinkelwert verglichen;
f. ist der gemessene Kontaktwinkel größer als der gewünschte Kontaktwinkelwert, wird erneut ein Ionenbeschuss mit einer Ionendosis pro Flächeneinheit durchgeführt, die doppelt so hoch ist wie die zuvor verwendete;
g. die Schritte c bis f werden wiederholt, bis die Ionendosis pro Flächeneinheit und die Beschleunigungsspannung der Ionen bestimmt sind, um einen gemessenen Kontaktwinkel zu erhalten, der kleiner oder gleich dem gewünschten Kontaktwinkelwert ist.

**10.** Verfahren nach einem der vorhergehenden Ansprüche, **dadurch gekennzeichnet, dass** das Kalk-Natron-Glasmaterial bezüglich des Stickstoff- oder Sauerstoffionenstrahls mit einer Geschwindigkeit $V_D$ zwischen 0,1 mm/s und 1000 mm/s beweglich ist.

**11.** Verfahren nach Anspruch 10, **dadurch gekennzeichnet, dass** derselbe Bereich des Kalk-Natron-Glasmaterials unter dem Stickstoff- oder Sauerstoffionenstrahl in einer Vielzahl von Durchgängen N mit der Geschwindigkeit $V_D$ bewegt wird.

**12.** Verfahren nach einem der vorhergehenden Ansprüche, welches zur Bearbeitung eines festen Kalk-Natron-Glasteils verwendet wird, gewählt aus der Liste, umfassend eine Automobil-Windschutzscheibe, ein Brillenglas, eine Linse einer optischen Vorrichtung, einen Spiegel, ein Gebäudefenster, eine optische Faser, einen Glasspritzenkörper.

**13.** Kalk-Natron-Glasteil mit mindestens einer hydrophilen Oberfläche, die nach einem der vorhergehenden Ansprüche behandelt wurde.

**Claims**

**1.** A treatment process for enhancing the hydrophilic properties of a soda-lime glass material, consisting of an ion bombardment where:

- the ions of the ion beam are selected from the ions of the elements of the list consisting of nitrogen (N) and oxygen (O);
- the acceleration voltage, AV, of the ions is greater than or equal to 5 kV and less than or equal to 1000 kV, in particular greater than or equal to 5 kV and less than or equal to 200 kV, indeed even greater than or equal to 10 kV and less than or equal to 100 kV;
- the temperature of the soda-lime glass material is less than or equal to the glass transition temperature;

- the dose of ions per unit of surface area is located within a range of between $10^{12}$ ions/cm$^2$ and $10^{18}$ ions/cm$^2$, in particular of greater than or equal to $10^{15}$ ions/cm$^2$, indeed even of greater than or equal to $10^{15}$ ions/cm$^2$ and less than or equal to $10^{17}$ ions/cm$^2$,

**characterized in that** the glass material forms the subject of a pretreatment for lastingly strengthening the hydrophilic treatment of claim 1, consisting of an ion bombardment, where:

- the ions of the ion beam are selected from the ions of the elements of the list consisting of argon (Ar), krypton (Kr) and xenon (Xe);
- the acceleration voltage of the ions is greater than or equal to 5 kV and less than or equal to 1000 kV;
- the temperature of the soda-lime glass material is less than or equal to the glass transition temperature;
- the dose of ions per unit of surface area is chosen within a range of between $10^{12}$ ions/cm$^2$ and $10^{18}$ ions/cm$^2$.

2. The process of claim 1, **characterized in that** the dose range for the argon (Ar) ions is between $5 \times 10^{16}$ and $5 \times 10^{17}$ ions per cm$^2$ in order to lastingly strengthen the hydrophilic properties.

3. The process of claim 1, **characterized in that** the dose range for the krypton (Kr) ions is between $10^{16}$ and $10^{17}$ ions per cm$^2$ in order to lastingly strengthen the hydrophilic properties.

4. The process of claim 1, **characterized in that** the dose range for the xenon (Xe) ions is between $5 \times 10^{15}$ and $5 \times 10^{16}$ ions per cm$^2$ in order to lastingly strengthen the hydrophilic properties.

5. The process of claim 1, **characterized in that** the dose of nitrogen ions or oxygen ions per unit of surface area is chosen within a range of between $5 \times 10^{15}$ ions/cm$^2$ and $10^{18}$ ions/cm$^2$ in order to reduce the contact angle of a drop of water below a value of less than or equal to 20°.

6. The process of any of claims 1-5, **characterized in that** the dose of ions per unit of surface area and the acceleration voltage of the nitrogen ions or oxygen ions are determined so that the surface atomic concentration is greater than or equal to an atomic concentration threshold of 0.1% for nitrogen and an atomic concentration threshold of 2.5% for oxygen.

7. The process of any of claims 1-6, **characterized in that** the ions of the ion beam are nitrogen (N), the acceleration voltage AV is greater than or equal to 10 kV and the dose of ions per unit of surface area is greater than or equal to a value DNmin = $(AV/20)^2$, where DNmin is expressed in $10^{16}$ ions/cm$^2$ and the acceleration voltage AV is expressed in kV.

8. The process of any of claims 1-6, **characterized in that** the ions of the ion beam are oxygen (O), the acceleration voltage AV is greater than or equal to 10 kV and the dose of ions per unit of surface area is greater than or equal to a value DOmin = $10.(AV/20)^{1.5}$, where DOmin is expressed in $10^{16}$ ions/cm$^2$ and the acceleration voltage AV is expressed in kV.

9. The process of any of claims 1-8, **characterized in that** the hydrophilic treatment process of the invention comprises a preliminary stage where the dose of nitrogen ions or oxygen ions per unit of surface area and the acceleration voltage of the said ions are determined according to the following stages:

a. an acceleration voltage of the ions between 10 kV and 100 kV is chosen;
b. a dose of ions per unit of surface area of between $10^{15}$ ions/cm$^2$ and $10^{17}$ ions/cm$^2$ is chosen;
c. a treatment according to the invention is carried out under the conditions chosen;
d. the contact angle of a drop of water on the glass material thus treated is measured;
e. the measured contact angle is compared with a desired value for contact angle;
f. if the measured contact angle is greater than the desired value for contact angle, a treatment according to the invention is again carried out with a dose of ions per unit of surface area double that previously used;
g. stages c to f are repeated until determining the dose of ions per unit of surface area and the acceleration voltage of the ions in order to obtain a measured contact angle less than or equal to the desired value for contact angle.

10. The process of any of claims 1-9, **characterized in that** the soda-lime glass material is movable with respect to the nitrogen ion beam or oxygen ion beam at a rate, $R_{FP}$, of between 0.1 mm/s and 1000 mm/s.

**11.** The process of any of claims 1-10, **characterized in that** the same region of the soda-lime glass material is moved under the nitrogen or oxygen ion beam according to a plurality, N, of passes at the rate $R_{FP}$.

**12.** The process of any of claims 1-11, utilized to treat a soda-lime bulk glass part chosen from the list consisting of a motor vehicle windshield, a spectacle lens, a lens of an optical device, a mirror, a window of a building, an optical fiber and a glass syringe body.

**13.** A soda-lime glass part comprising at least one hydrophilic surface treated according to the process of any of claims 1-12.

EP 2 978 717 B1

Fig 1

Fig. 2

EP 2 978 717 B1

Fig. 3

A

Fig. 4

Fig. 5

**EP 2 978 717 B1**

**RÉFÉRENCES CITÉES DANS LA DESCRIPTION**

**Documents brevets cités dans la description**

- US 4948760 A

- US 6300641 B